# EUROPEAN PATENT APPLICATION

(11) **EP 0 561 712 A2**
(43) Date of publication of application: **22.09.1993**
(21) Application number: 93400716.2
(22) Date of filing: 22.03.1993
(51) Int. Cl.: G01R 11/02, G01D 4/00

(54) **Induction watt hour meter non-intrusive and concealed pulse initiator**

(30) Priority: 20.03.1992 CA 2063620
(71) Applicant: SCHLUMBERGER CANADA LIMITED, Toronto Ontario M4G 3X1 (CA)
(72) Inventor: Baker, Steven A., Duluth, Georgia 30136 (US); Hartman, Marinus (NMI), Pickering, Ontario L1W 1G5 (CA); Purc, Marc M., Islington, Ontario M9A 3H5 (CA)
(74) Representative: Hawkes, David John

(57) **Abstract**

An electro-mechanical induction watt hour meter having a rotatable disc and a projection on the base directed into the meter terminating in proximity of the rotatable disc. The projection is part of a pulse initiator system where a pulse signal is transmitted through a selected area of the base that is transparent to the signal. A signal is generated externally of the meter and chopped by rotation of the disc providing a pulse signal that passes through the base of the meter to a receptor externally of the meter. The signal generator and the pulse signal receptor are both located in the enclosure defined by the base of the meter and the receptacle socket for the meter. The generated signal is disclosed as a light beam that, by way of light guides on the meter base, is directed to one side of the rotating disc and is directed by the light guide to the other side of the disc where another light guide returns the chapped or pulsed signal to a receptor externally of the meter.

## Description

### Field of Invention

The invention relates generally to electromechanical induction watt hour meters and particularly to improvements for generating a pulse signal correlated to the rate of electrical power usage for further processing to provide additional information as may be required.

### Background of Invention

Watt hour meters most commonly used as electric energy billing meters are the simple induction electro-mechanical meters. These meters have proven to have a high degree of accuracy and reliability through many years of service under varying ambient operating conditions. The reliability of these meters is exemplified by the fact accrediting authorities in Canada require only sample testing of meters from which a number of meters can be sealed for a period of twelve years and this can be extended for on up to eight years indefinitely depending upon the accuracy criteria.

There is a growing demand for electricity and existing utilities are forecasting a supply shortage by the year 2000 leaving them one of three options, namely, (a) create new generating facilities; (b) purchase power from independent producers and (c) conserve.

To create a conservation of electricity there is what is known as Demand Side Management (DSM) which relates to electric utilities deliberate activities designed to influence customer use of electricity in a way that will produce the desired changes in the utility's electric load. Electric utilities are seeing DSM as an alternative to additional generating capacity. DSM requires a good understanding of how customers use electricity and why. It would be of great assistance if the residential meter assisted in this information gathering and in allowing for multi-rate billing. In multi-rate billing normally the rate normally depends on the time of use of the electricity.

Traditionally, enhancing the function of the residential meter require the addition of application-specific electronics to the meter. This results in a sophisticated highly specialized and thus expensive meter. This expensive meter would replace and displace a perfectly operational electro-mechanical induction watt hour meter. It is also worthy to note that such meter replacement would involve ongoing updating of detailed meter tracking records.

A watt hour meter may be enhanced by incorporating electronic circuits within the meter. But this reduces meter reliability.

It is thus most desirable to separate the electronics from the conventional electro-mechanical portion of the watt hour meter but at the same time have a signal generated with a predetermined relationship to the rate of electrical power usage.

Enhancing the function of an electro-mechanical watt hour meter without incorporating additional apparatus within the meter is known as exemplified by the teachings of U.S. patents 4,415,853; 4,922,187 and 4,646,003.

United States patent 4,646,003, issued February 24, 1987 to Charles E. Phillips, discloses apparatus for verifying the accuracy of a meter and includes means externally of the meter for generating a pulse signal responsive to rotation of the disc. There is a light generating source external to the meter and a light receiving means external to the meter arranged so that the light beam from the source to the receiver is chopped by the revolving disc which has an aperture near the periphery of the disc that comes into and out of alignment with the beam as the disc rotates. The viewing of the disc is done through the glass cover of the meter. The light generating source and receiver is mounted on arms extending from a casing positionable as an intermediate housing between the meter and the meter receiving socket.

United States patent 4,922,187, issued May 1, 1990 to William C. Beverly II, discloses a pulse initiator circuit for utility meters where the pulse indicator is attachable to the meter without breaking the meter seal. The pulse initiator circuit detects sensor holes in the watt hour meter rotor disk. A source of radiation positioned outside of the watt hour meter directs a beam toward a receiver and the beam impinges upon the rotor disk except for when aligned with the hole in the rotor. This causes a pulse signal having a predetermined relationship to the rate at which the rotor disk turns. In the patented structure the light radiating and receiving source is mounted in an annular ring that fits onto the glass cover of the meter.

United States patent 4,415,853 issued November 15,1983 to Berish M. Fisher, discloses a scanner device mounted so as to detect the presence of a marking on the rotating disc and therefrom generate a pulse signal. In this patented structure, as in the two previously mentioned patented structures, the light source and receiver are of considerable distance from the rotating disc by virtue of the fact they are external to the meter cover. They are further more located in the vicinity of the glass cover making them susceptible to extraneous radiation source signals. Also by virtue of the fact they are located in surrounding relation to the exposed part of the meter they are subjected directly to ambient conditions as well as being prone to vandalism or unwanted manipulation.

In all of the foregoing, the pulse indicator is located externally of the meter at a position forwardly of the base of the meter in proximity of the glass cover.

Since the traditional electro-mechanical induction watt hour residential meter is very reliable and economical, it is not cost effective to replace it at present with a solid state meter. Hence enhancing the traditional meter's function involves counting the meter's disc revolutions and using a micro-processor to manipulate this information to produce whatever rate structures or features are required.

### Summary of Invention

In accordance with the present invention there is provided an electro-mechanical induction watt hour meter comprising the following: a base; a cover supported on said base so as to form an enclosure, at least a portion of said cover being transparent; an electromechanical apparatus within said enclosure and means for connecting said electromechanical apparatus to an electrical circuit; said electromechanical apparatus including a disk mounted for rotation at a rate proportional to energy being consumed by said circuit, said disk having a peripheral portion with an peripheral segment located in proximity to said base; pulse generation means including.means associated with said peripheral portion of said disk for use in generating a pulse signal related to the rate of rotation of said disk; and signal direction means proximate said peripheral segment of said disk means for passing a pulse signal through said base.

This arrangement locates the pulse generation means in a secure place as it is within the enclosure and extends through the base and the meter base, in use, is mounted to a service box. This position also eliminates the need to expose communication wires etc. preventing others from tampering with them and also protecting the wires from direct elements of the environment. Optical sensing is disclosed hereinafter but obviously other sensing systems may be used such as capacitive, inductive or magnetic coupling or radio active communication if so desired.

### List of Drawings

The invention is illustrated by way of example in the accompanying drawings wherein:
Figure 1 is an exploded side-elevational view illustrating the major components of the electro-mechanical watt hour meter;
Figure 2 is an oblique view of the register housing and rotatable disc portion of the meter illustrated in Figure 1;
Figure 3 is an enlarged, oblique, partial diagrammatic, view of the base of the meter without the potential and current induction coils mounted thereon illustrating co-positioning of the two prong light guide and the rotatable disc;
Figure 4 is a partial side elevational view, on a larger scale, illustrating the two prong light guide;
Figure 5 is a top plan view of Figure 4;
Figure 6 is a left hand side elevational view of Figure 5;
Figure 7 is a diagrammatic illustration of different rotational positions of the disc and a hole therein chopping the light beam; and
Figure 8 is a diagrammatic illustration of the logic sequence for two receptors relative to the rotational positions for the disc shown in Figure 7.

### Description of the Preferred Embodiment

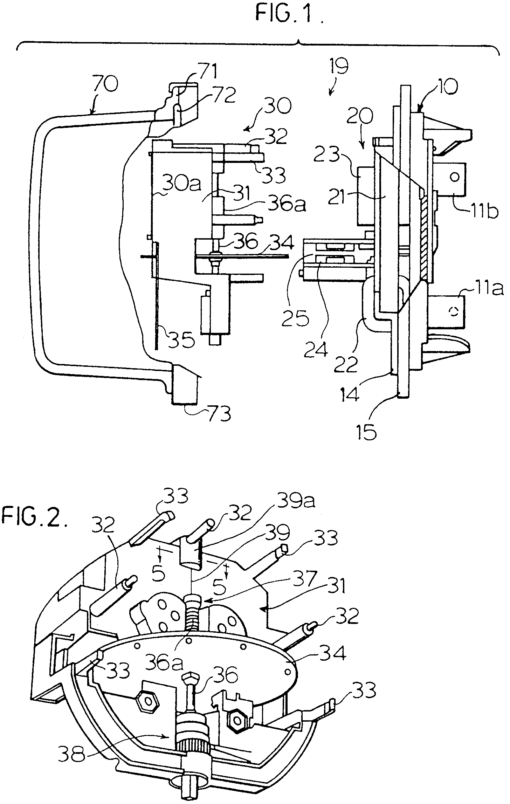

Figure 1 is an exploded view of the electro-mechanical induction watt hour meter the major components of which are a base 10, an electro magnetic unit 20 with a disc brake magnet mounted thereon, a register and rotary unit 30 and a transparent glass cover 70. The base and cover, when joined, form an enclosure indicated generally at 19.

The electro magnetic unit 20 has a core unit 21 with respective current and potential coils 22 and 23 mounted thereon. A magnetic brake 24 is carried by the unit 20 and has a gap 25 for receiving a portion of rotor disk 34. The unit 20 securely attaches to the molded base 10 and has pairs of current spades 11a and 11b projecting through and anchored to the base for connection to an electric circuit. The base and spade attachment thereto is the subject of Canadian application No. 2,063,618-1 filed March 20, 1992. Base 10 is molded conventionally from a hard thermoset plastics material such as a phenolic resin (bakelite). Applicant prefers using a rigid thermoplastic such as a polycarbonate material identified as #9417 Makrolon* available from the Bayer Company of Germany. The polycarbonate material is preferably glass fiber reinforced and ultraviolet light stabilized. This material is somewhat more resilient than the hard phenolic bases conventionally used. The magnetic coil unit 20 attaches to the base in a convenient manner, for example, lugs projecting from the base which position and snap fit onto the unit 20.
* Trade Mark

The register and rotor 30 is a module that includes a molded plastics (preferably Ryton* PPS) housing 31 having a plurality of spacer lugs 32 projecting therefrom and attaching lugs 33 for precisely locating unit 30 relative to unit 20 and attaching unit 30 to the base with coil unit 20 mounted thereon. The unit 30 has a register, diagrammatically illustrated by its face designated 30A, driven through a gear train by a worm gear 36A on the shaft 36 of the rotatable disc 34. A name plate 35 attaches to and extends downwardly from the molded plastic housing 31. The locating lugs 32 position the unit 30 relative to unit 20 such that rotating disc 34 fits into the gap 25 and lugs 33 snap fasten onto as previously mentioned the coil unit 20 and/or base unit 10.

When the current spades are connected to a circuit, current is carried through the current coil 22 and potential coil 23 inducing flux in the electromagnetic unit 20 to rotate disc 34 in response to, and proportional to, the energy being consumed.

With reference to Figure 2, the disk 34 is mounted on shaft 36 having respective upper and lower bearing units 37 and 38 on the molded plastic housing unit 31. The bearing units mounting the rotor is the subject of Canadian application No. 2,063,617-3 filed March 20, 1992. A pintle 39, associated with the upper bearing 37, projects therefrom into a pintle receiving unit 39A on the molded plastic housing 31. Worm gear 36A on the upper end of rotor shaft 36 meshes with a drive gear (not shown) for driving the gear train of the registry unit. Dials of the registry unit visually indicate the cumulative energy consumed.

Returning to Figure 1, the glass cover 70 has an outwardly directed flange 71 and a seat portion 72 that abuts against a seal forming rib 14 on the base 10. The outwardly directed flange 71 carries a metal ring 73 provided with lugs that engage tapered ramps on the flange 15 of the base forming a bayonet type mount whereby the glass cover and base may be rotated relative to one another to detachably join them together with the rib 14 on the base being pressed against the seat 72 on the glass cover.

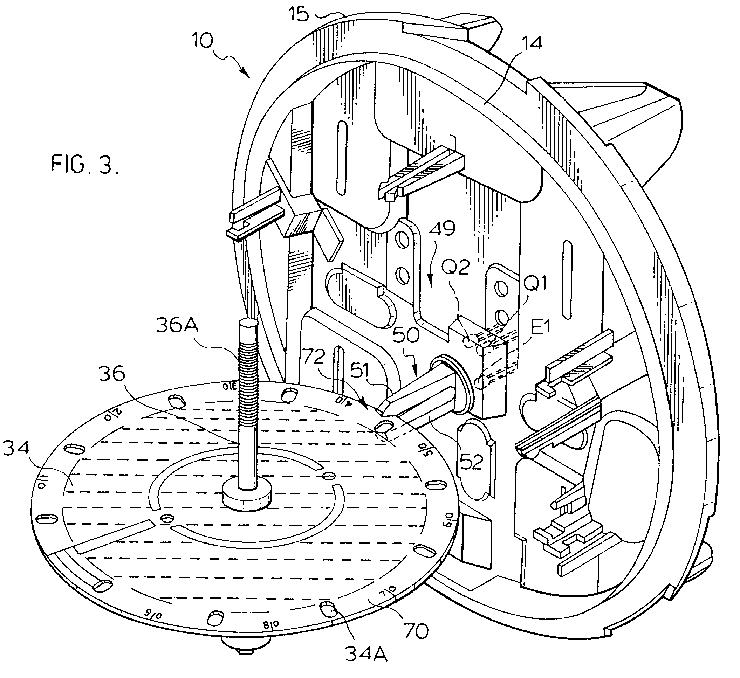

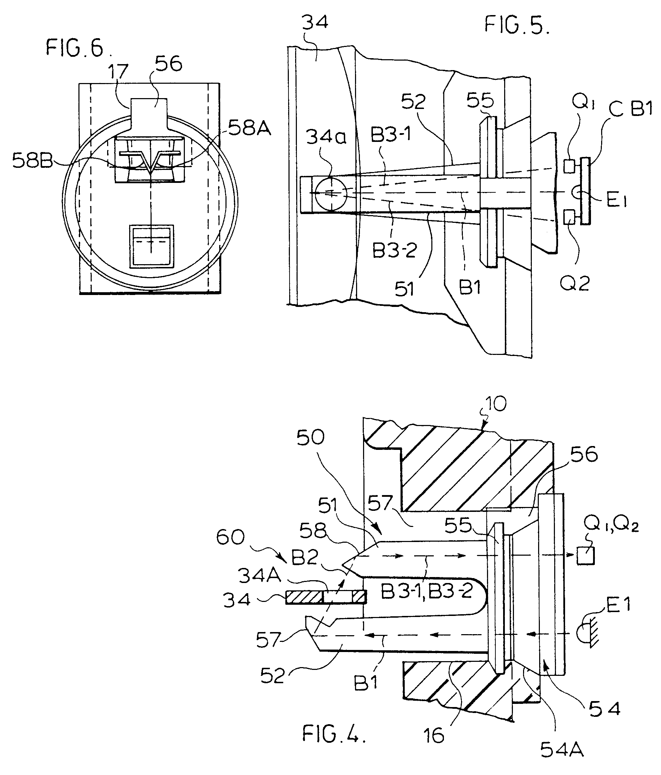

The present application is particularly directed to apparatus, and the physical location of such apparatus, for initiating a pulse signal in response to rotation of the disc 34. Turning to figure 3, it is noted that disk 34 has a peripheral portion 70 with apertures 34A and a peripheral segment 72 of the disk is in close proximity to base 10. The pulse initiator apparatus is indicated generally at 49 and comprises a signal direction means in the nature of a fork type two prong light guide unit 50 mounted on the base 10. The unit 50 is a translucent light receptor-transmitter made for example from clear acrylic. The light guide unit projects from the base to overlap Peripheral segment 72 of the disc 34, The light guide unit 50 has an upper leg 51 and a lower leg 52 spaced a selected distance from one another providing a gap therebetween to receive a peripheral edge segment 60 of the disc 34 as is seen in Figure 4. The disc may have a thickness of about 40/1000 of an inch while the gap may be, for example, approximately 110/1000 of an inch. The legs 51 and 52 project forwardly from a base 54 that has an outwardly directed rib 55 for snap fitting into a suitably shaped and formed aperture 16 in the base 10. A sloped shoulder 54A on the base limits the inward movement of the unit when press fit in place and co-operates with rib 55 to ensure a snug fit. Projecting outwardly from the base 54 is a locating rib 56 that slip fits into a slot 17 (seen in Figure 6) in a wall of the aperture 16. The locating lug 56 and slot 17 ensure appropriate positioning along with rib 55 of the legs 51 and 52 relative to an aperture 34A (or series of apertures) through disc 34. There may be only one aperture 34A or a series of apertures 34A, as illustrated in Figure 3, equally spaced from one another in a circle around the disc and spaced inwardly from the peripheral edge thereof. One light guide leg is shorter than the other and in this embodiment the upper leg 51 is shorter than the lower leg 52.

Diagrammatically illustrated in Figures 4 and 5 is a light emitting diode E1 associated with the lower leg 52 for directing a beam of light B1 along the inside of leg 52 of the translucent unit 50. Associated with the upper leg are respective ones of a pair of phototransistor receivers designated Q1 and Q2.

The phototransistors Q1 and Q2 and light emitting diode E1 are mounted on a separate printed circuit board designated CB1 in Figure 5 mounted in a conventional service socket or an interbase assembly inserted between the electric service socket and the meter. It is important to note that the light source (light emitting diode) E1, receptors (photo-transistors) Q1, Q2 and all controlling electronics therefore reside outside of the meter enclosure 35. Thus, the electronics may be replaced without disturbing the integrity of the meter.

By way of explanation, an interbase assembly may be used as a housing for the pulse-pickup electronics and whatever other circuits are required to manipulate the pulse data to perform the appropriate functions and features. The interbase is a socket to socket adapter which plugs into the service box and, in turn, has the meter plugged into it. The current terminals in the interbase simply extend those of the service box to meet the meter while providing space to house the electronics and access to line voltage to power the electronics. The interbase may have a chamber which extends below the profile of the meter. This chamber can be equipped with a door, a wire trap and/or knock-outs. Each of these offer alternate methods of accessing the interbase electronics. For example, the interbase may be equipped with a modem for communication of the metering data directly to the Electric Utility. The wire trap provides secure access for a telephone cable to tie into the lower chamber of the interbase. Once inside the lower chamber of the interbase a wire can be routed directly to an appropriate connector on the circuit board. Alternately, a strip holding a number of terminal connectors may be provided in the lower chamber as a common point to connect wires and cables for communication outside the interbase, and hence outside the meter. An example interbase unit is further described in U.S. patent 4,121,147 issued October 17, 1978 to Dale F. Becker.

Light emitted by the light emitting diode E1 enters the light guide unit 50 forming a beam of light B1 transmitted through the lower leg 52 to a light reflecting surface 57 that directs the light into a reflected beam B2. If an aperture 34A is located between legs 51, 52, the reflected beam B2 passes through disc 34 and is reflected by reflecting surface 58 on leg 51 resulting in a further reflected beam or beams B3-1, B3-2 directed to the receivers Q1, Q2. The reflecting surface 58 on leg 51 has a projecting V-shaped rib providing respective angularly related planar faces 58A and 58B (Figure 6) causing two reflected beams B3-1 and B3-2 (Figure 5) to travel along leg 51. In an alternative arrangement, surface 58 could be a plane surface and there could be one receiver.

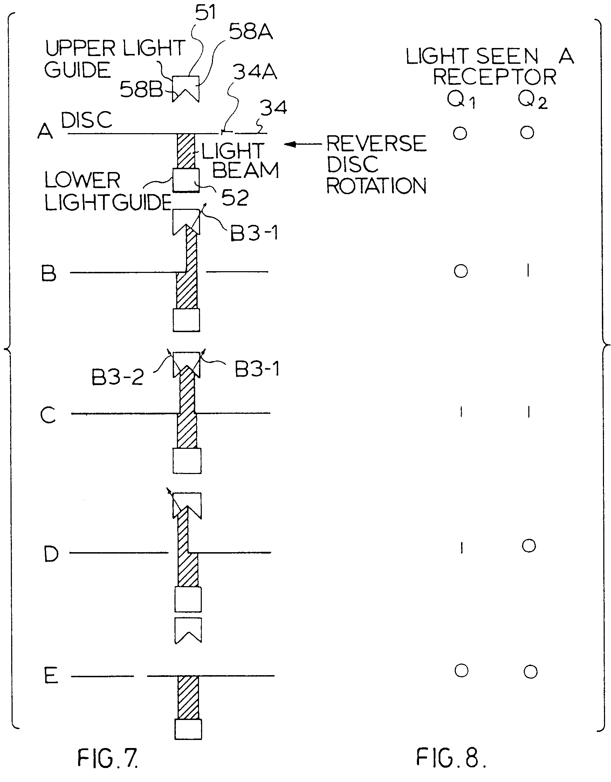

Since Q1 and Q2 are physically displaced from one another, the light beam generated by E1 passing through the hole will appear first on either Q1 or Q2 depending upon the direction of rotation of the disc. Additional circuity therefore can be used to determine the direction of rotation of the disc and hence forward or reverse energy flow. This is diagrammatically illustrated in Figures 7 and 8 wherein 7 diagrammatically illustrates the disc 34 with the aperture 34A in 5 different rotational positions designated A, B, C, D and E. A representative aperture 34A in the disc is shown moving in Figure 7 from right to left. Figure 8 diagrammatically illustrates the logic for respective disc positions A, B, C, D, & E for the reflected beam as viewed at respective photo-transistor units Q1 and Q2.

Directional rotation of the disc is detected by the reflected light beams resulting from the slightly angled planes of reflecting surface 58. As the leading edge of the hole in the disc crosses the light beam it reveals first one reflecting surface and then both. As the trailing edge of the hole crosses the light beam it blocks the first reflecting plane and moves across to block the beam completely. In this method the receptor pairs Q1 and Q2 see logic 0-0 as the disc completely blocks the light beam, logic 1-0 as the leading edge of the hole exposes the first reflecting plane, logic 1-1 as the light hits both reflecting planes, logic 0-1 as the trailing edge of the hole blocks light from the first reflecting surface then finally 0-0 as the hole passes and the disc again blocks the beam of light. Similarly the same results could be achieved if the beam of light were split before it reaches the disc. In such instance the split beams would be directed onto the disc in such a manner that the hole would pass first in front of one beam then the other permitting detecting forward and reverse disc rotation.

A single hole in the disc may be used which will give one pulse per disc revolution or a number of holes spaced circumferentially in a ring may be used. Increasing the number of holes, increases the resolution and ten holes is proposed offering resolution to 1/10 of a disc revolution.

While an optical solution has been chosen to initiate a pulse, other technologies could achieve the same results, for example, technology such as magnetic coupling, capacitive coupling, inductive coupling and radio active communication are possible. Other optical solutions are also available and while disclosed herein is chopping of a beam of light by the apertured disc the same could be achieved if the light were reflected off the surface of disc or its outer peripheral edge. Similarly various optical solutions could implement a range of optical wavelengths from visible to infrared and laser, infrared being preferred by the applicant.

From the foregoing it will be clearly evident the pulse initiator apparatus is hidden from view, is protected by being located in the mounting base and is located closely adjacent a peripheral edge of the rotary disc. There are no active components mounted within the enclosure thereby avoiding the risk or requiring additional testing of the meter while at the same time providing means to generate information not possible with a conventional electro-mechanical induction watt hour meter.

The plastics for the molded housing, pilot bearings and meter base are engineering grade resins and preferably rigid thermoplastic materials such as those identified hereinbefore.

## Claims

1. An electro-mechanical induction watt hour meter comprising the following:
- a base;
- a cover supported on said base so as to form an enclosure, at least a portion of said cover being transparent;
- an electromechanical apparatus within said enclosure and means for connecting said electromechanical apparatus to an electrical circuit; said electromechanical apparatus including a disk mounted for rotation at a rate proportional to energy being consumed by said circuit, said disk having a peripheral portion with an peripheral segment located in proximity to said base;
- pulse generation means including means associated with said peripheral portion of said disk for use in generating a pulse signal related to the rate of rotation of said disk; and
- signal direction means proximate said peripheral segment of said disk means for passing a pulse signal through said base.

2. The meter of claim 1 wherein said signal direction means is mounted to said base.

3. The meter of claim 2 wherein said signal direction means includes means to receive an input signal and wherein said pulse signal generation means includes signal generation and reception means mounted outside of said enclosure and operatively associated with said signal direction means.

4. The meter of claim 3 wherein said signal direction means includes a projection projecting from said base to a free end adjacent said peripheral segment of said disk.

5. The meter of claim 4 wherein said projection comprises a pair of legs forming a gap receiving said peripheral segment of said disk.

6. The meter of claim 5 including means to pass a signal from said signal generation and reception means through one of said legs toward the other of said legs.

7. The meter of claim 6 wherein said legs are light guides and wherein said means associated with said peripheral portion of said disk are apertures through said disk whereby light input to one of said legs is directed toward the other of said legs and is intermittently passed by said apertures in said disk to said other of said legs in order to provide light pulses.

8. An improved electro-mechanical induction watt hour meter having a transparent cover attached to a base and together forming an enclosure containing an electro-mechanical apparatus with a disc that rotates in proportion to the energy being comsumed, the improvement comprising means disposed at a location where said disc is in near proximity to the base of the meter for use in generating a pulse signal responsive to the rate of rotation of the rotatable disc and means for passing the so generated pulse signal through said base to a receptor disposed externally of the meter.

9. An improved meter as defined in claim 8 including means externally of the meter for generating a signal, means for directing said generated signal to said disc at said location, and means associated with said rotatable disc to interrupt said generated signal in response to the rate of rotation of said disc and thereby cause a pulse signal.

10. The improved meter as defined in claim 9 mounted on a meter receiving socket forming an enclosure externally of the meter and wherein said signal generating means and a receptor for the pulse signal are located in said meter socket enclosure.

11. A method of enhancing information availability from an electro-mechanical induction watt hour meter comprising generating a pulse signal responsive to the rate of rotation of the disc of the watt hour meter at a location where the peripheral edge of the disc is in proximity to the base of the meter and passing said pulse signal through said base of the meter to a receptor and from which such pulse signal can be accessed to provide an output control pulse signal representative of electrical energy being used as detected by the watt hour meter.

12. A improved electro-mechanical induction watt hour meter having a transparent cover attached to a base and together forming an enclosure containing an electro-mechanical apparatus with a disc that rotates in proportion to the energy being consumed, a peripheral portion of said disc being located in near proximity to said base, means on said base projecting into said meter enclosure for use in generating a pulse signal responsive to the rate of rotation of said disc and means for passing the so generated pulse signal through said base to a receptor disposed externally of the meter.

13. A watt hour meter as defined in claim 12 wherein a portion of said projection extends beyond the peripheral edge of said disc adjacent thereto.

14. A watt hour meter as defined in claim 13 wherein a free outer end of said projection has a gap receiving therein a portion of said peripheral edge of said disc, said gap being provided by an upper leg portion and a lower leg portion.

15. A watt hour meter as defined in claim 14 including means on said disc causing a signal transmitted by way of said legs to pulse in response and proportional to rotation of the disc.

16. A watt hour meter as defined in claim 15 wherein said legs are wave guides for a light beam and including means for directing a light beam from one arm to the other adjacent a peripheral edge of the disc, said disc having means for interrupting such beam as the disc rotates.
